# EUROPÄISCHE PATENTSCHRIFT

(11) **EP 2 596 517 B1**
(45) Veröffentlichungstag und Bekanntmachung des Hinweises auf die Patenterteilung: **05.09.2018**
(21) Anmeldenummer: 11726130.5
(22) Anmeldetag: 14.06.2011
(51) Int. Cl.: H01J 37/32

(54) **ARCLÖSCHANORDNUNG UND VERFAHREN ZUM LÖSCHEN VON ARCS**
ARC QUENCHING ASSEMBLY AND METHOD FOR QUENCHING ARCS
AGENCEMENT D'EXTINCTION D'ARCS ET PROCÉDÉ D'EXTINCTION D'ARCS

(30) Priorität: 20.07.2010 DE 102010031568
(43) Veröffentlichungstag der Anmeldung: 29.05.2013
(73) Patentinhaber: TRUMPF Hüttinger GmbH + Co. KG, 79111 Freiburg im Breisgau (DE)
(72) Erfinder: RICHTER, Ulrich, 79106 Freiburg (DE)
(74) Vertreter: Kohler Schmid Möbus Patentanwälte
(86) Internationale Anmeldenummer: PCT/EP2011/059812
(87) Internationale Veröffentlichungsnummer: WO 2012/010374

(56) Entgegenhaltungen:
- EP-A1- 1 720 195
- EP-A1- 1 995 818
- WO-A1-2008/138573
- US-A- 5 815 388
- US-A1- 2008 061 794

## Beschreibung

Die Erfindung betrifft ein Verfahren zur Löschung eines Arcs in einer Gasentladungskammer, bei dem Leistung einer Gasentladungskammer zugeführt wird, in der sowohl bei einem Stromfluss in einer ersten Richtung als auch bei einem Stromfluss in einer zweiten umgekehrten Richtung jeweils eine Gasentladung erzeugt wird, bei dem bei Erkennen eines Arcs die Leistungszufuhr zur Gasentladungskammer unterbrochen wird.

Außerdem betrifft die Erfindung eine Arclöschanordnung, die zumindest abschnittsweise eine Zuleitung zwischen einer Leistungsversorgung und einer Elektrode einer Gasentladungskammer umfasst, wobei in der Gasentladungskammer sowohl bei einem Stromfluss in einer Richtung als auch bei einem Stromfluss in einer zweiten umgekehrten Richtung jeweils eine Gasentladung erzeugbar ist, mit einer Arclöscheinrichtung.

Vakuumplasmageneratoren sind in unterschiedlichen Leistungsklassen und mit unterschiedlichen Ausgangssignalformen bekannt.

In der Vakuum-Glasbeschichtung werden beispielsweise Mittelfrequenz (MF) Generatoren mit MF-Ausgangssignal mit Leistungen zwischen 30 und 300kW eingesetzt. Das MF-Signal ist zumeist ein Sinus-Signal mit Frequenzen zwischen 10kHz und 200kHz. Die Ausgangsspannungen können dabei mehrere 100V bis über 1000V betragen. Zum Zünden des Plasmas liegen die Spannungen oft noch viel höher als im Normalbetrieb.

Im Plasma kann es zu kurzzeitigen und auch länger anhaltenden Überschlägen, so genannten Arcs, kommen, die unerwünscht sind. Ein Arc wird in der Regel durch ein Zusammenbrechen oder Absinken der Spannung und ein Ansteigen des Stroms, insbesondere am Ausgang des Generators oder an einer anderen Stelle im Generator erkannt. Wenn ein solcher Arc erkannt wird, muss dafür gesorgt werden, dass dieser möglichst rasch erlischt, bzw. sich nicht voll entfaltet.

Aus der EP 1 720 195 A1 ist eine Arclöschanordnung in einer mit einer Wechselspannung, insbesondere MF-Wechselspannung, betriebenen Gasentladungseinrichtung, mit einer Arclöscheinrichtung und einer dieser ansteuernden Arcerkennungseinrichtung bekannt, wobei die Arclöscheinrichtung zumindest einen steuerbaren Widerstand aufweist, der in Serienschaltung in einer von einer Wechselspannungsquelle zu einer Elektrode der Gasentladungseinrichtung führenden elektrischen Leitung angeordnet ist. Als steuerbarer Widerstand ist ein Schalter, insbesondere ein IGBT, vorgesehen. Bei Erkennen eines Arcs werden die Schalter so leitend geschaltet, dass in ihnen bewusst elektrische Energie in Wärme umgewandelt wird. Dabei wird die Sperrschicht im IGBT sehr stark erhitzt, sodass nur einige wenige Arcs in Folge behandelt werden können, ohne dass es zu einer Zerstörung des IGBTs kommt.

Aus der EP 1 995 818 A1 ist eine Schaltungsanordnung zur Reduzierung der elektrischen Energie, die in einer Leitung gespeichert ist, die eine Leistungsversorgung mit einer Last verbindet, bekannt. Die Schaltungsanordnung umfasst wenigstens ein Schaltelement, mit dem die Leistungszufuhr von der Stromversorgung zu der Last aktiviert oder unterbrochen werden kann. Die Schaltungsanordnung umfasst weiterhin ein erstes elektrisches nicht lineares Bauteil, einen Energiespeicher, der in Serie zu dem Bauteil angeordnet ist, und einen Vorladeschaltkreis.

Aufgabe der vorliegenden Erfindung ist es deshalb, ein Verfahren zur Löschung eines Arcs und eine Arclöscheinrichtung bereitzustellen, die auch bei erhöhten Arcraten eingesetzt werden können.

Gelöst wird diese Aufgabe durch ein Verfahren mit den Merkmalen des Anspruchs 1 und eine Arclöschanordnung mit den Merkmalen des Anspruchs 6.

Erfindungsgemäß ist vorgesehen, dass bei Erkennen eines Arcs Restenergie, die in einer Zuleitung zur Gasentladungskammer und/oder in der Gasentladungskammer vorhanden ist, einem Energiespeicher zugeführt wird. Auf diese Art und Weise kann die Restenergie für den Plasmaprozess deutlich reduziert werden. Mit dem erfindungsgemäßen Verfahren kann eine sehr schnelle, effiziente Arclöschung erfolgen. Die Arcenergie kann sehr stark und schnell reduziert werden. Außerdem können durch das erfindungsgemäße Verfahren Bauteile in der Gasentladungskammer jedoch auch in der Ansteuerung der Elektroden der Gasentladungskammer geschont werden.

Bei Erkennen eines Arcs wird die Leistungszufuhr zur Gasentladungskammer durch Öffnen von zumindest einem Schalter unterbrochen und die Spannung über dem Schalter auf eine Spannung eines Energiespeichers begrenzt. Dabei kann Restenergie, die in einer Zuleitung zur Gasentladungskammer und/oder in der Gasentladungskammer vorhanden ist, dem Energiespeicher zugeführt werden. Zusätzlich kann auch Restenergie, die noch in Streuinduktivitäten eines Ausgangstrafos oder einer Induktivität eines Ausgangsschwingkreises vorhanden ist, dem Energiespeicher zugeführt werden. Auf diese Weise wird verhindert, dass diese Energie dem Arc zugeführt wird.

Durch nichtlineare Bauelemente kann der Rückfluss von Energie aus dem Energiespeicher in die Zuleitung zur Gasentladungskammer und/oder in der Gasentladungskammer vermindert oder unterbunden werden. Dies führt zu einem sehr schnellen Verlöschen eines Arcs bei extrem geringer Restenergie in der Gasentladungskammer. Die Arcenergie kann schnell und effizient reduziert werden.

Der Grad der Zerstörung in der Gasentladungskammer kann dadurch reduziert werden. Die Verlustleistung in Schaltern kann reduziert werden, so dass das Verfahren auch bei hohen Arcraten, z. B. > 2kHz, einsetzbar ist.

Der Energiespeicher kann im arcfreien Betrieb, also im Normalbetrieb, auf einen vorgegebenen Speicherzustand vorgeladen werden. Durch diese Maßnahme kann die Arclöschung beschleunigt werden.

Weiterhin kann vorgesehen sein, dass der Energiespeicher nach erfolgter Arclöschung auf einen vorgegebenen Speicherzustand entladen wird. Somit wird sichergestellt, dass der Energiespeicher beim Auftreten des nächsten Arcs wieder ausreichend Restenergie aufnehmen kann. Zu Beginn der Arcbehandlung liegt somit immer der gleiche Ausgangszustand vor. Außerdem kann durch diese Maßnahme der Energiespeicher vor Zerstörung geschützt werden.

Es ist vorgesehen, dass sowohl Restenergie verursacht durch Stromfluss in die erste Richtung als auch Restenergie verursacht durch Stromfluss in die zweite Richtung ausschließlich einem (demselben) Energiespeicher zugeführt wird. Es ist daher nicht notwendig, zwei unterschiedliche Energiespeicher für unterschiedliche Stromrichtungen vorzusehen. Dies führt zu einem einfacheren Aufbau der Schaltung, der Reduzierung teurer Bauteile und ermöglicht eine vereinfachte Vorladung und Entladung des Energiespeichers.

Durch die Zuführung der Restenergie in den Energiespeicher kann eine Spannungsumkehr in den Zuleitungen, insbesondere den Leitungsinduktivitäten der Zuleitungen, erzeugt werden. Dies hat eine schnellere Arclöschung zur Folge.

Die Umschaltung von Zufuhr der Leistung zur Gasentladung hin zur Unterbrechung dieser Zufuhr und Zuführung der Restenergie in den Energiespeicher kann mittels nur einem Ansteuersignal durchgeführt werden, indem zwei elektronische Schalter zeitgleich mit dem Ansteuersignal angesteuert und insbesondere geöffnet werden.

Die Schalter können als IGBT, als MOSFET oder anderer elektronischer Schalter ausgebildet sein.

Die zwei Schalter können baugleich sein. Daraus ergibt sich ein einfacher Aufbau der Schaltung, durch die das Verfahren implementiert wird. Teure Bauteile können reduziert werden. Die Inbetriebnahme und Überwachung werden vereinfacht.

Während der Zuführung der Leistung zur Gasentladungskammer können die zwei elektronischen Schalter geschlossen sein und bei Erkennung eines Arcs können diese Schalter geöffnet werden. Dies führt zu einer Reduzierung der Verlustleistung in den Schaltern. Damit ist das Verfahren auch bei hohen Arcraten (> 2kHz) einsetzbar.

Während der Zuführung der Leistung zur Gasentladung kann zumindest ein Schalter geschlossen sein und bei Erkennen eines Arcs kann dieser Schalter geöffnet werden. Dadurch wird die Verlustleistung in den Schaltern reduziert.

Die erfindungsgemäße Arclöschanordnung weist eine Arclöscheinrichtung mit einem Energiespeicher zur Aufnahme von in einer Zuleitung zur Gasentladungskammer und/oder in der Gasentladungskammer vorhandener Energie auf. Dies ermöglicht eine sehr schnelle, effiziente Arclöschung. Die Arcenergie wird reduziert und Bauteile in der Gasentladungskammer werden geschont.

Mit einer solchen Anordnung kann auch Restenergie, die noch in Streuinduktivitäten eines Ausgangstrafos eines Ausgangsschwingkreises vorhanden ist, dem Energiespeicher zugeführt werden. Auf diese Weise wird verhindert, dass diese Energie dem Arc zugeführt wird.

Die Gasentladung in der Gasentladungskammer wird sowohl bei einem Stromfluss in einer ersten Richtung als auch bei einem Stromfluss in einer umgekehrten Richtung erzeugt. Dabei kann ein Arc in der Gasentladungskammer entstehen. Durch Vorsehen eines Energiespeichers kann verhindert werden, dass der Arc weiterhin mit Energie versorgt wird. Insbesondere kann auch Arcenergie aus der Gasentladungskammer abgeleitet und dem Energiespeicher zugeführt werden.

Die Arclöscheinrichtung kann nichtlineare Bauelemente aufweisen, die derart angeordnet sind, dass ein Leistungsfluss aus dem Energiespeicher in die Zuleitungen und die Gasentladungskammer vermindert oder verhindert wird. Dabei kann insbesondere vorgesehen sein, dass die Arclöscheinrichtung zumindest einen Schalter aufweist, der in Serienschaltung in einer von der Energieversorgungsvorrichtung zu einer der Elektroden der Gasentladungskammer führenden Zuleitung angeordnet ist und der durch Ansteuerung mittels eines Ansteuersignals bei Arcerkennung öffenbar ist. Dadurch ergibt sich ein einfacher Aufbau der Schaltung. Verluste im Schalter können reduziert werden. Dadurch ist es möglich, auf eine erhöhte Arcfrequenz zu reagieren.

Es kann eine mit der Arclöscheinrichtung in Verbindung stehende Arcerkennungseinrichtung mit einer mit dem Schalter verbundenen Ansteuerschaltung vorgesehen sein. Dadurch ist es möglich, die Arcdauer, eine Arcreaktionsschwelle und eine Verzögerungszeit bis zur Reaktion auf einen Arc einzustellen. Die Ansteuerschaltung kann auch zum periodischen oder aperiodischen Pulsen, z. B. zur prophylaktischen Arcvorbeugung, eingesetzt werden.

Der Energiespeicher kann einen Kondensator umfassen. Die Restenergie, die z, B. in Induktivitäten der Zuleitung gespeichert ist, kann am schnellsten in einen anderen Energiespeicher umgeladen werden, wenn der Energiespeicher ein Kondensator ist. Vorzugsweise sind weiterhin Dioden vorgesehen, mit denen sich auf schaltungstechnisch sehr einfache Weise der Rückfluss der Energie in die Zuleitung unterbinden lässt.

Häufig ist der größte Anteil der Restenergie in den Induktivitäten der Zuleitungen und/oder des Ausgangsschwingkreises gespeichert. Dann ist es besonders vorteilhaft, wenn diese Restenergie in einen Kondensator umgeladen wird. Für Anordnungen, in denen ein Großteil der Restenergie in Kapazitäten, z.B. der Zuleitungen und/oder der Gasentladungskammer gespeichert ist, kann der Energiespeicher eine Induktivität sein.

Es kann eine Gleichspannungsquelle zur Vorladung des Energiespeichers vorgesehen sein. Eine Gleichspannung kann einfach zur Verfügung gestellt werden. Sie kann sehr einfach galvanisch getrennt von einem Massepotenzial zur Verfügung gestellt werden, was in diesem Fall vorteilhaft ist. Sie kann auf einfache Weise gegebenenfalls auch sehr schnell geregelt werden und den oft unterschiedlichen Gasentladungsprozessen mit unterschiedlichem Arcverhalten angepasst werden. Ein Knotenpunkt einer Zuleitung kann über ein gleichrichtendes Element, insbesondere eine Diode, mit dem Kondensator des Energiespeichers zur Vorladung des Energiespeichers verbunden sein. Mit einer derart ausgestalteten Schaltung kann der Energiespeicher, insbesondere eine Kapazität, einfach vorgeladen werden. Außerdem wird keine zusätzliche galvanisch getrennte Spannungsversorgung benötigt. Dadurch ist die Spannung des Kondensators der Spannung des Plasmaprozesses angepasst.

Dem gleichrichtenden Element kann ein Gleichspannungsregler nachgeschaltet sein.

Die Arclöscheinrichtung kann symmetrisch aufgebaut sein, wobei zwei in Serie angeordnete Dioden und zwei Schalteranordnungen vorgesehen sind, und der Energiespeicher zwischen den Verbindungspunkt der Dioden und den Verbindungspunkt der Schalteranordnungen geschaltet ist. Dadurch entsteht eine einfache, schnelle Schaltung mit einer minimalen Anzahl aktiver Bauteile. Würden mehr aktive Bauteile benötigt, würde die Geschwindigkeit der Arcreaktion verringert werden.

Die Schalteranordnungen können jeweils zumindest einen IGBT aufweisen dem eine antiparallele Diode zwischen Kollektor und Emitter parallel geschaltet ist. Dies ermöglicht die Verwendung standardisierter Bauteile, die breite Verwendung in der Leistungselektronik finden und deswegen zuverlässig und kostengünstig verfügbar sind.

Es können Module vorgesehen sein, die die Schalter und Dioden aufweisen. Dadurch können Bauteile reduziert werden und eine störungsfreie Verdrahtung sichergestellt werden. Die Zuverlässigkeit der Gesamtschaltung kann dadurch verbessert werden.

Weiterhin kann eine Gleichspannungsquelle mit galvanischer Trennung zu einem Massepotenzial zur Vorladung des Energiespeichers vorgesehen sein. Eine Gleichspannung kann sehr einfach zur Verfügung gestellt werden. Außerdem kann sie einfach galvanisch getrennt von einem Massepotenzial zur Verfügung gestellt werden, was im vorliegenden Fall vorteilhaft ist. Sie kann auf einfache Art und Weise gegebenenfalls auch schnell geregelt werden und den zum Teil unterschiedlichen Gasentladungsprozessen angepasst werden.

Es kann vorgesehen sein, dass die Arclöschanordnung keine galvanische Verbindung zu einem Massepotenzial aufweist. Dadurch wird die Zuverlässigkeit der Arclöschanordnung verbessert, da sie unabhängig von Störungen auf Leitungen gegenüber dem Erdpotenzial oder Störungen auf Erdverbindungen selbst ist.

Die Schalter können im Plasmabetrieb geschlossen sein und im Fall der Arclöschung geöffnet werden. Dadurch werden Verluste im Schalter reduziert und kann auf erhöhte Arcraten reagiert werden.

Zudem kann eine Entladungsvorrichtung zum Entladen des Energiespeichers vorgesehen sein, Dadurch kann der Energiespeicher bis zu einem vorgegebenen Speicherzustand entladen werden. Es kann somit sichergestellt werden, dass der Energiespeicher immer denselben Ausgangszustand aufweist, wenn Restenergie aufgenommen werden muss.

Es kann eine Spannungsüberwachung vorgesehen sein, die bei Überschreiten eines vorgegebenen Spannungswerts die Entladungsvorrichtung zum Entladen des Energiespeichers aktiviert. Dadurch kann der Energiespeicher vor Überspannung geschützt werden.

Weiterhin kann eine Spannungsüberwachung vorgesehen sein, die bei Unterschreiten eines vorgegebenen Spannungswerts die Entladungsvorrichtung zum Entladen des Energiespeichers deaktiviert. Dadurch kann die Spannung am Energiespeicher einfach geregelt werden. Es sind somit vorgebbare Werte zur Arclöschung einstellbar.

Es kann eine Stromüberwachung vorgesehen sein, die bei Überschreiten eines vorgegebenen Stromwerts die Entladungsvorrichtung zum Entladen des Energiespeichers aktiviert. Dadurch kann der Energiespeicher vor Überstrom geschützt werden.

Weiterhin kann eine Stromüberwachung vorgesehen sein, die bei Unterschreiten eines vorgegebenen Stromwerts die Entladungsvorrichtung zum Entladen des Energiespeichers deaktiviert. Dadurch kann der Strom am Energiespeicher einfach geregelt werden. Es sind somit vorgebbare Werte zur Arclöschung einstellbar.

Die dem Energiespeicher entnommene Energie kann in der Entladungsvorrichtung in Wärme umgewandelt werden. Dadurch kann eine einfache und kostengünstige Energieumwandlung bei niedrigen Arcraten erfolgen. Dem Energiespeicher kann entnommene Energie zumindest teilweise über eine der Entladungsvorrichtung nachgeschaltete Energieumwandlungsvorrichtung der Leistungsversorgung rückführbar sein. Eine solche Ausführungsform ist zwar etwas aufwändiger, dafür aber energie- und platzsparend, zumindest bei Anwendungen mit einer hohen Arcrate, bei denen die Umwandlung der Energie in Wärme häufig sehr viel Platz benötigt, da die Wärmeumwandlung auf eine große Oberfläche verteilt werden muss.

An den Schaltern kann eine Spannungsbegrenzerschaltung vorgesehen sein. Dadurch kann sichergestellt werden, dass die Schalter so weit wie möglich im Schaltbetrieb arbeiten und die Energie nicht in den Schaltern in Wärme umgewandelt wird, sondern in den Energiespeicher umgeladen wird. Dennoch müssen die Schalter vor Überspannung geschützt werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug zu den Figuren der Zeichnung näher erläutert.

Es zeigt:
- Fig. 1a: eine erste Ausführungsform einer Wechselspannungsgasentladungsanregungsanordnung, die an eine Gasentladungskammer eingeschlossen ist;
- Fig. 1b: eine alternative Ausführungsform der Wechselspannungsgasentladungsanregungsanordnung;
- Fig. 2: ein Ausführungsbeispiel einer Arclöscheinrichtung;
- Fig. 3: ein zweites Ausführungsbeispiel einer Arclöscheinrichtung;
- Fig. 4: ein drittes Ausführungsbeispiel einer Arclöscheinrichtung;
- Fig. 5: eine Arclöschanordnung mit Spannungsbegrenzerschaltung.
- Fig. 6: eine Arclöschanordnung mit Energieumwandlungsvorrichtung
- Fig. 7: ein Zeitverlauf von Strom und Spannung an der Arclöscheinrichtung

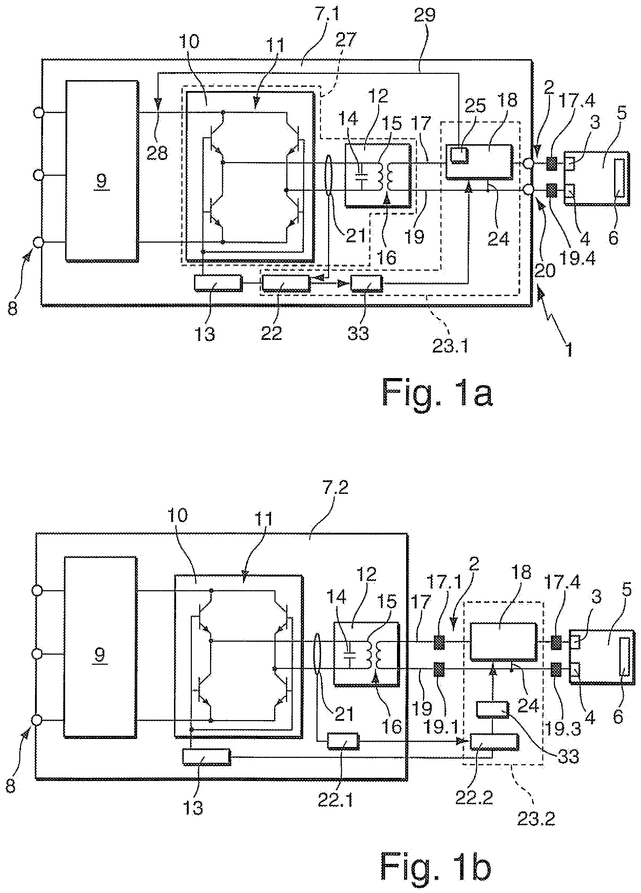

In der Fig. 1a ist eine Wechselspannungsgasentladungsanregungsanordnung 1 dargestellt, die über Zuleitungen 2 an Elektroden 3, 4 einer Gasentladungskammer 5, insbesondere einer Plasmaanlage, angeschlossen ist. Die Elektroden 3, 4 sind in der Gasentladungskammer 5 angeordnet, in der ein Werkstück 6 bearbeitet wird.

Die Wechselspannungsgasentladungsanregungsanordnung 1 umfasst einen Wechselspannungsgenerator 7.1, der einen Netzanschluss 8, der ein- oder mehrphasig sein kann, aufweist. An den Netzanschluss 8 ist ein Netzgleichrichter 9 angeschlossen, der weitere Bauelemente aufweisen kann, wie beispielsweise einen DC/DC - Wandler. An seinem Ausgang liegt eine so genannte Zwischenkreisgleichspannung. Dem Netzgleichrichter 9 nachgeschaltet ist ein Spannungsumformer 10, der eine Brückenschaltung 11 umfasst. Durch den Spannungsumformer 10 wird ein Ausgangsschwingkreis 12 angesteuert. Das Ausgangssignal des Spannungsumformers 10 wird durch eine den Spannungsumformer 10 ansteuernde Spannungsumformersteuerung 13 eingestellt. Der Spannungsumformer 10 und der Ausgangsschwingkreis 12 können als Leistungsversorgung 27 , insbesondere als Wechselspannungs- oder Wechselstromquelle, betrachtet werden. Der Ausgangsschwingkreis 12 kann wie hier dargestellt ein Parallelresonanzkreis sein oder als Serienresonanzkreis ausgeführt sein.

Der Ausgangsschwingkreis 12 umfasst einen Kondensator 14 sowie die Streuinduktivität 15 eines Ausgangtransformators 16. Durch den Ausgangstransformator 16 kann eine galvanische Trennung durchgeführt werden. Außerdem kann er zur Spannungseinstellung verwendet werden. Um die Resonanzfrequenz optimal einstellen zu können, kann der Kondensator 14 einstellbar sein. In die zur Elektrode 3 der Gasentladungskammer 5 führende Zuleitung 17 ist eine Arclöscheinrichtung 18 in Serie geschaltet. Zwischen den Zuleitungen 17, 19 sowie am Ausgangsanschluss 20 des Wechselspannungsgenerators 7.1 liegt im Normalbetrieb eine Mittelfrequenz (MF) - Wechselspannung mit Frequenzen von 5 kHz bis 500 kHz an.

Kommt es in der Gasentladungskammer 5 zu einem Lichtbogen (Arc), so wirkt sich das auf Strom und/oder Spannung und/oder Leistung im Wechselstromgenerator 7.1 aus. Eine oder mehrere dieser Größen können beispielsweise durch eine Messeinrichtung 21, die zwischen Spannungsumformer 10 und Ausgangsschwingkreis 12 angeordnet ist, gemessen werden. Die Messeinrichtung 21 könnte jedoch auch an einer anderen Stelle im Wechselspannungsgenerator 7.1 oder sogar gasentladungskammerseitig angeordnet sein.

Aufgrund der durch die Messeinrichtung 21 gemessenen Größe(n) kann eine Arcerkennungseinrichtung 22 bestimmen, ob ein Arc aufgetreten oder im Entstehen ist. Die Arcerkennungseinrichtung 22 stellt ebenso wie die Arclöscheinrichtung 18 einen Teil einer Arclöschanordnung 23.1 dar. Die Arcerkennungseinrichtung 22 steht außerdem mit der Spannungsumformersteuerung 13 in Verbindung. Sie kann diese so beeinflussen, dass beim Erkennen eines Arcs die Brückenschaltung 11 so angesteuert wird, dass keine Energie mehr aus dem Spannungsumformer 10 in Richtung des Ausgangsschwingkreis 12 fließt. Die Arclöscheinrichtung 18 weist einen Energiespeicher auf, dem Restenergie, z. B. aus (Leitungs-) Induktivitäten 17.1, 19.1, 17.4, 19.4 oder der Gasentladungskammer 5 beim Auftreten eines Arcs zugeführt wird. Die Induktivitäten 17.1, 19.1 können auch Anteile von Streuinduktivitäten des Ausgangtransformators 16 darstellen oder enthalten. Die Induktivitäten 17.4 und 19.4 stellen im Wesentlichen die Zuleitungsindutkivitäten dar, die die Zuleitungen 2 vom Wechselspannungsgenerator 7.1 zu den Elektroden 3, 4 einer Gasentladungskammer 5 aufweisen.

Optional kann die Zuleitung 19 auch mit der Arclöscheinrichtung 18 verbunden sein, was mit der Bezugsziffer 24 angedeutet ist.

Optional kann die Arclöscheinrichtung 18 eine Energieumwandlungsvorrichtung 25 aufweisen, die die im Energiespeicher zugeführte Energie in Gleichspannungsleistung umwandelt und über eine Verbindung 29 einem Gleichspannungsversorgungspunkt 28 im Wechselspannungsgenerator 7.1 zuführt. Der Gleichspannungsversorgungspunkt 28 kann beispielsweise die Zwischenkreisgleichspannung sein.

Die Fig. 1b entspricht im Wesentlichen der Fig. 1a mit dem Unterschied, dass die Arclöschanordnung 23.2 außerhalb des Wechselspannungsgenerators 7.2 angeordnet ist. Dies bedeutet, dass die Arclöscheinrichtung 18 in einer der Zuleitungen 2 zur Gasentladungskammer 5 angeordnet ist. Es kann dabei eine Arcerkennungseinrichtung 22.1 im Wechselspannungsgenerators 7.2 und/oder eine Arcerkennungseinrichtung 22.2 in der Arclöschanordnung 23.2 angeordnet sein.

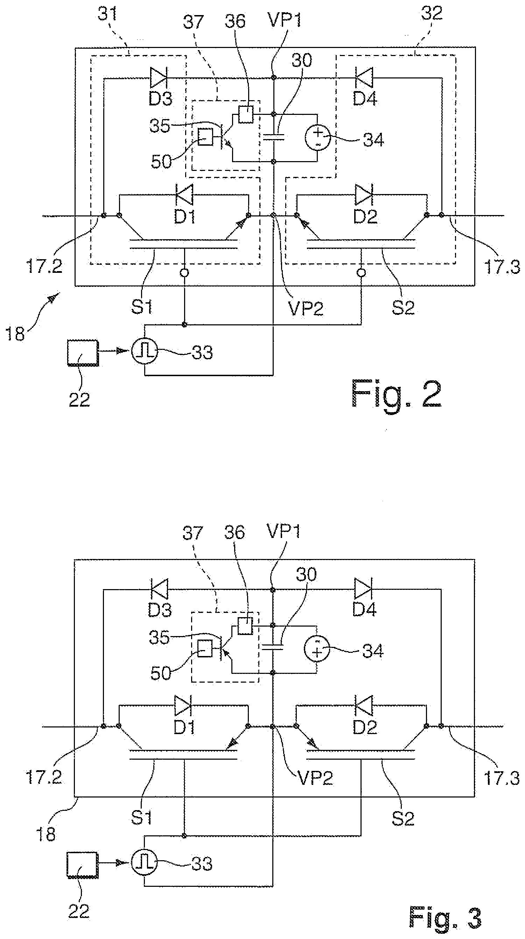

Die Figur 2 zeigt eine erste Ausführungsform einer symmetrisch aufgebauten Arclöscheinrichtung 18. Die Arclöscheinrichtung 18 weist Zuleitungsabschnitte 17.2, 17.3 auf. Ein Energiespeicher 30 ist im Ausführungsbeispiel als Kondensator ausgebildet. Der Energiespeicher 30 ist über einen als IGBT ausgebildeten Schalter S1 und eine dazu antiparallel geschaltete Diode D1 mit dem Zuleitungsabschnitt 17.2 verbunden. Weiterhin ist er über den als IGBT ausgebildeten Schalter S2 und die dazu antiparallel geschaltete Diode D2 mit dem Zuleitungsabschnitt 17.3 verbunden. Der andere Anschluss des Energiespeichers 30 ist zum einen über die Diode D3 mit dem Zuleitungsabschnitt 17.2 und über die Diode D4 mit dem Zuleitungsabschnitt 17.3 verbunden. Die Bauelemente S1, D1 und D3 können in einem vorgefertigten Modul 31 und die Bauelemente S2, D2 und D4 in einem vorgefertigten Modul 32 angeordnet sein. Die Dioden D3, D4 sind in Serie geschaltet. Der Schalter S1 bildet mit der Diode D1 eine Schalteranordnung und der Schalter S2 bildet mit der Diode D2 eine Schalteranordnung. Der Energiespeicher 30 ist zwischen den Verbindungspunkt VP1 der Dioden D3, D4 und den Verbindungspunkt VP2 der Schalteranordnungen geschaltet. Die Kathoden der Dioden D3, D4 sind mit dem Verbindungspunkt VP1 verbunden. Die Anode der Diode D3 ist mit dem Zuleitungsabschnitt 17.2 verbunden. Die Anode der Diode D4 ist mit dem Zuleitungsabschnitt 17.3 verbunden.

Im Falle einer Arcerkennung werden die im Normalbetrieb geschlossenen Schalter S1, S2 geöffnet. Dadurch fließt ein Strom nicht mehr über die Dioden D1, D2 und Schalter S1, S2 sondern über die Dioden D3, D4 zu den Dioden D2, D1. Energie in den Zuleitungen 17, 19 und in der Gasentladungskammer 5 wird in den Energiespeicher 30 geladen. Aufgrund des Schaltzustands der Schalter S1, S2, die nichtlineare Bauelemente darstellen, und der Anordnung der Dioden D1-D4 wird ein Rückfluss von Energie aus dem Energiespeicher 30 in die Zuleitungen 17, 19 und insbesondere die Gasentladungskammer 5 verhindert. Dabei werden nur zwei baugleiche Module 31, 32 benötigt, die je einen Schalter S1 und S2 und je zwei Dioden D1, D3 und D2, D4 aufweisen. Die Umladung von Energie in den Energiespeicher 30 funktioniert unabhängig davon, welche Halbwelle der Wechselspannung gerade an der Gasentladungskammer 5 anliegt bzw. unabhängig von der Richtung des Stromflusses in der Gasentladungskammer 5.

Eine Ansteuerschaltung 33 zur Ansteuerung der Schalter S1, S2 kann mit der Arcerkennungseinrichtung 22 in Verbindung stehen oder ein Teil von ihr sein. Parallel zum Energiespeicher 30 ist eine galvanisch getrennte Gleichspannungs- oder Gleichstromquelle 34 vorgesehen, um den Energiespeicher 30 vorladen zu können. Weiterhin ist parallel zum Energiespeicher 30 eine einen Schalter 35 und einen Widerstand 36 aufweisende Entladungsvorrichtung 37 vorgesehen, über die der Energiespeicher 30 entladen werden kann. Eine Spannungsüberwachung 50 überwacht den Ladungszustand des Energiespeichers 30 und aktiviert die Entladungsvorrichtung 37, wenn ein vorgegebener Spannungswert überschritten wird bzw. deaktiviert sie, wenn ein Spannungswert unterschritten wird.

Die Figur 3 zeigt eine alternative Ausgestaltung einer Arclöscheinrichtung 18.1. Der Unterschied zur Figur 2 liegt darin, dass die Bauelemente S1, S2, D1, D2 und D3, D4 in umgekehrter Orientierung eingebaut sind.

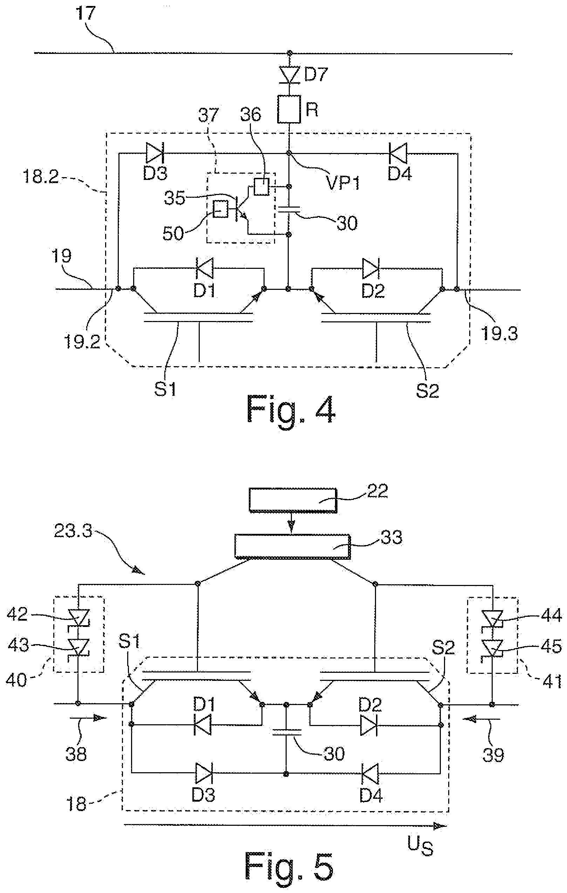

Die Figur 4 zeigt eine Ausgestaltung, bei der eine Arclöscheinrichtung 18.2 in der Zuleitung 19 angeordnet ist und außerdem eine Verbindung zur Zuleitung 17 aufweist. Die Arclöscheinrichtung 18.2 weist Zuleitungsabschnitte 19.2, 19.3 auf. Im Unterschied zur Arclöscheinrichtung 18 weist die Arclöscheinrichtung 18.2 keine Gleichspannungs- oder Gleichstromquelle 34 auf. Dafür ist der Energiespeicher 30 über eine Diode D7 und einen Widerstand R mit der Zuleitung 17 verbunden. Zusätzlich zum Widerstand R kann ein Spannungs- oder Stromregler oder eine Kombination aus beiden eingesetzt werden. Der Vorteil der Arclöscheinrichtung 18.2 ist, dass keine zusätzliche galvanisch getrennte Spannungsversorgung zur Aufladung des Energiespeichers benötigt wird. Außerdem ist die Spannung des Energiespeichers 30 der Spannung des Plasmaprozesses angepasst. Wenn dies nicht erwünscht ist, könnte anstatt des Widerstands R zur Strombegrenzung eine Spannungs- und/oder Stromregelschaltung eingesetzt werden. Dabei wird keine galvanische Trennung benötigt.

In der Fig. 5 ist eine Ausgestaltung einer Arclöschanordnung 23.3 dargestellt, die sowohl als Arclöschanordnung 23.1 in der Anordnung der Fig. 1 als auch als Arclöschanordnung 23.2 in der Anordnung der Fig. 2 einsetzbar ist. Die Arclöschanordnung 23.3 umfasst zwei entgegengesetzt angeschlossene, in Serie geschaltete, als IGBTs ausgebildete Schalter S1, S2. Zu den Schaltern S1, S2 ist jeweils eine Diode D1, D2 parallel geschaltet, wobei die Dioden D1, D2 mit zum jeweiligen Schalter S1, S2 entgegengesetzter Durchlassrichtung angeordnet sind. Die Schalter S1, S2 sind durch die Arcerkennungseinrichtung 22 angesteuert.

Es ist in Fig. 5 auch für jeden Schalter S1, S2 eine Spannungsbegrenzerschaltung 40 und 41 gezeigt, die jeweils zwei Z-Dioden 42, 43, 44, 45 umfassen. Im Normalbetrieb sind die Schalter S1, S2 leitend geschaltet. Dies bedeutet, dass ein Stromfluss in Pfeilrichtung 38 über den Schalter S1 und die Diode D2 erfolgt und ein Stromfluss in Pfeilrichtung 39 über den Schalter S2 und die Diode D1 erfolgt.

Wird ein Arc erkannt, so steuert die Arcerkennung 22 die Schalter S1, S2 derart an, dass diese öffnen. Ein Stromfluss durch die Schalter S1, S2 ist dadurch weder in Pfeilrichtung 38 noch in Pfeilrichtung 39 möglich. Sobald die Spannungsbegrenzerschaltung 41 jedoch eine Spannung feststellt, die einem vorgegebenen Wert überschreitet, werden die Schalter S1, S2 wieder leitend geschaltet. Dies dient dem Schutz der Schalter vor sie selbst zerstörender Überspannung. In der Regel wird die Spannung an den Schaltern durch die Spannung über den Kondensator 30 begrenzt und die Z-Dioden 42, 43, 44, 45 sind so ausgewählt, dass die Spannungsbegrenzerschaltungen 40, 41 nicht aktiv werden. Da aber in der Schaltung inhärente Induktivitäten vorhanden sind und sich Sperrschichten von Dioden im Durchlassbetrieb mit Ladungsträgern aufladen, die im Sperrbetrieb wieder entladen werden, können kurzzeitige sehr hohe Spannungsspitzen auftreten, die die Schalter zerstören könnten. Aus diesem Grund sind die Spannungsbegrenzerschaltungen 40, 41 vorgesehen. Die Schalter S1, S2 werden soweit wie möglich im Schaltbetrieb betrieben, so dass möglichst wenig Energie in Wärme umgewandelt wird sondern möglichst viel Energie in den Energiespeicher 30 umgeladen wird.

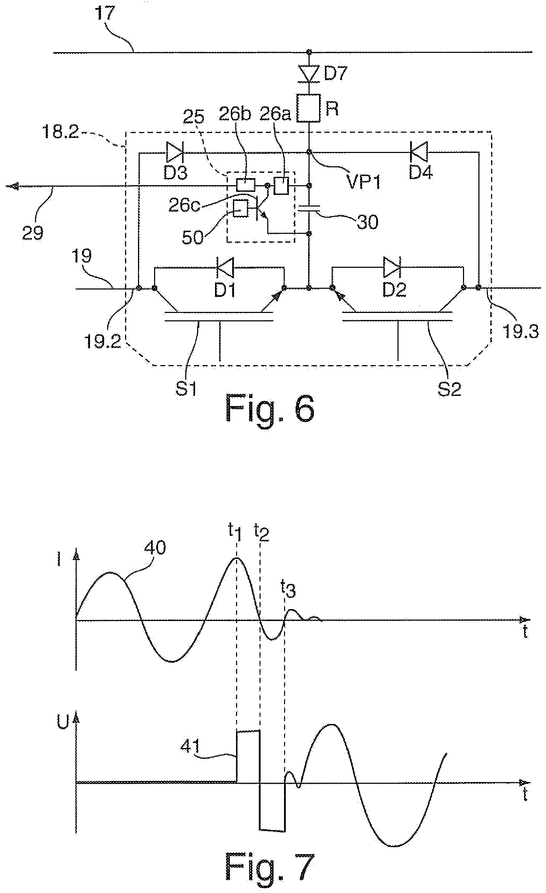

In Fig. 6 ist die Schaltung von Fig. 4 gezeigt. Hier ist die Entladungsvorrichtung 37 ersetzt durch eine Energieumwandlungsvorrichtung 25, die diverse Bauteile 26a, 26b, 26c aufweist, die wahlweise zu einem Hochsetzsteller, Tiefsetzsteller oder anderem DC/DC Wandler mit oder ohne galvanische Trennung zusammengeschaltet sein können. Die Energieumwandlungsvorrichtung 25 kann anders als die Entladungsvorrichtung 37 die Energie nicht nur vollständig in Wärme umwandeln, sondern zumindest zu einem Teil der Leistungsversorgung 27 oder einem anderen Energieverbraucher wieder zuführen. Dazu kann sie eine geregelte Gleichspannung oder einen geregelten Gleichstrom erzeugen. Eine Umwandlung in Wechselspannung oder Wechselstrom ist ebenfalls denkbar. Ein Gleichstrom kann über die Verbindung 29 einer Zwischenkreisgleichspannung des Wechselspannungsgenerators 7.1 zugeführt werden.

In Fig. 7 sind Stromverlauf 40 und Spannungsverlauf 41 an der Arclöscheinrichtung 18, 18.1, 18.2 gezeigt. Der Stromverlauf 40 zeigt den zeitlichen Verlauf eines Stroms, wie er in die Arclöscheinrichtung 18, 18.1, 18.2 hinein oder heraus fließt. Beispielhaft kann der Stromverlauf 40 ein Strom in Richtung des Pfeils 38 oder 39 in Fig. 5 sein. Für die folgende Beschreibung wird ein Stromverlauf 40 in Richtung des Pfeils 38 angenommen. Der Spannungsverlauf 41 entspricht dann dem Spannungsverlauf der Spannung Us über die Schalter S1, S2 in Fig.5. Zum Zeitpunkt t1 werden die Schalter S1, S2 geöffnet und der Stromfluss durch diese Schalter unterbunden. Ein Strom in Richtung des Pfeils 38 wird nun weiter fließen über die Dioden D3, D2 und den Energiespeicher 30. An D3, D2 fällt im Vergleich zur Spannung am Energiespeicher 30 nur eine verschwindend geringe Spannung ab. Restenergie, die in einer Zuleitung 17, 19 zur Gasentladungskammer 5 und/oder in der Gasentladungskammer 5 und /oder in Induktivitäten des Ausgangsschwingkreises 12 vorhanden ist, wird dem Energiespeicher 30 zugeführt, der sich damit weiter auflädt. Die Spannung kann deswegen geringfügig ansteigen. Der Strom fällt, verursacht durch die anliegende Spannung, schnell ab. Zum Zeitpunkt t2 wechselt er seine Richtung und fließt nun durch die Dioden D4, D1. Die Spannung Us am Schalter S1, S2 kehrt sich um und bremst den umgekehrt fließenden Strom weiter. Zum Zeitpunkt t3 wechselt der Strom seine Richtung erneut ist nun aber auf ein verschwindend geringes Maß abgesunken. Wenn die Schalter wie im gezeigten Beispiel geöffnet bleiben, fällt an ihnen nun die Wechselspannung verursacht von der Leistungsversorgung 27 ab.

## Patentansprüche

1. Verfahren zur Löschung eines Arcs in einer Gasentladungskammer (5), bei dem Leistung einer Gasentladungskammer (5) zugeführt wird und in der sowohl bei einem Stromfluss in einer ersten Richtung als auch bei einem Stromfluss in einer zweiten umgekehrten Richtung jeweils eine Gasentladung erzeugt wird, bei dem bei Erkennen eines Arcs die Leistungszufuhr zur Gasentladungskammer (5) unterbrochen wird, wobei bei Erkennen eines Arcs Restenergie, die in einer Zuleitung (17, 19) zur Gasentladungskammer (5) und/oder in der Gasentladungskammer (5) vorhanden ist, einem Energiespeicher (30) zugeführt wird und bei Erkennen eines Arcs die Leistungszufuhr zur Gasentladungskammer (5) durch Öffnen von zwei Schaltern (S1, S2), die in einer Zuleitung (17, 19) angeordnet sind und die mit dem Energiespeicher verbunden sind, unterbrochen wird, indem die Schalter (S1, S2) bei Arcerkennung geöffnet werden und die Spannung (Us) über zumindest einem Schalter (S1, S2) auf eine Spannung des Energiespeichers (30) begrenzt wird, wobei sowohl Restenergie verursacht durch Stromfluss in die erste Richtung als auch Restenergie verursacht durch Stromfluss in die zweite Richtung ausschließlich einem Energiespeicher (30) zugeführt wird.

2. Verfahren nach Anspruch 1, **dadurch gekennzeichnet, dass** durch nichtlineare Bauelemente der Rückfluss von Energie aus dem Energiespeicher (30) in die Zuleitung (17, 19) zur Gasentladungskammer (5) und/oder in der Gasentladungskammer (5) vermindert oder unterbunden wird.

3. Verfahren nach Anspruch 1 oder 2, **dadurch gekennzeichnet, dass** der Energiespeicher (30) im arcfreien Betrieb auf einen vorgegebenen Speicherzustand vorgeladen wird.

4. Verfahren nach einem der vorhergehenden Ansprüche, **dadurch gekennzeichnet, dass** der Energiespeicher (30) nach erfolgter Arclöschung auf einen vorgegebenen Speicherzustand entladen wird.

5. Verfahren nach einem der vorhergehenden Ansprüche, **dadurch gekennzeichnet, dass** durch die Zuführung der Restenergie in den Energiespeicher (30) eine Spannungsumkehr in den Zuleitungen (17, 19) erzeugt wird.

6. Arclöschanordnung (23.1, 23.2, 23.3), die zumindest abschnittsweise eine Zuleitung (17, 19) für die Verbindung zwischen einer Leistungsversorgung und einer Elektrode (3, 4) einer Gasentladungskammer (5) umfasst, wobei in der Gasentladungskammer (5) sowohl bei einem Stromfluss in einer ersten Richtung als auch bei einem Stromfluss in einer zweiten umgekehrten Richtung jeweils eine Gasentladung erzeugbar ist, mit einer Arclöscheinrichtung (18, 18.1, 18.2), wobei die Arclöscheinrichtung einen Energiespeicher zur Aufnahme von in einer Zuleitung zur Gasentladungskammer und/oder in der Gasentladungskammer vorhanden Energie aufweist und wobei die Arclöscheinrichtung (18, 18.1, 18.2) zwei Schalter (S1, S2) aufweist, die in einer von der Leistungsversorgung zu einer der Elektroden (3, 4) der Gasentladungskammer (5) führenden Zuleitung (17, 19) angeordnet sind und die bei Arcerkennung zur Unterbrechung der Leistungszufuhr öffenbar sind, wobei die Schalter (S1, S2) mit dem Energiespeicher (30) derart verbunden sind, dass die Spannung (Us) über zumindest einem Schalter (S1, S2) auf eine Spannung des Energiespeichers (30) begrenzt wird und die Arclöschanordnung (23.1, 23.2, 23.3) eingerichtet ist, dass sowohl Restenergie verursacht durch Stromfluss in die erste Richtung als auch Restenergie verursacht durch Stromfluss in die zweite Richtung ausschließlich einem Energiespeicher (30) zugeführt wird.

7. Arclöschanordnung nach Anspruch 6, **dadurch gekennzeichnet, dass** die Arclöscheinrichtung (18, 18.1, 18.2) nichtlineare Bauteile, insbesondere Dioden (D3, D4), aufweist, die derart angeordnet sind, dass ein Leistungsfluss aus dem Energiespeicher (30) in die Zuleitungen (17, 19) und die Gasentladungskammer (5) vermindert oder verhindert wird.

8. Arclöschanordnung nach einem der vorhergehenden Ansprüche 6 bis 7, **dadurch gekennzeichnet, dass** ein Knotenpunkt (VP1) einer Zuleitung über ein gleichrichtendes Element, insbesondere eine Diode (D7), mit einem Kondensator des Energiespeichers (30) zur Vorladung des Energiespeichers (30) verbunden ist.

9. Arclöschanordnung nach einem der vorhergehenden Ansprüche 6 bis 8, **dadurch gekennzeichnet, dass** die Arclöscheinrichtung (18, 18.1, 18.2) symmetrisch aufgebaut ist, wobei zwei in Serie angeordnete Dioden (D3, D4) und zwei Schalteranordnungen vorgesehen sind und der Energiespeicher (30) zwischen den Verbindungspunkt (VP1) der Dioden (D3, D4) und den Verbindungspunkt (VP2) der Schalteranordnungen geschaltet ist.

10. Arclöschanordnung nach einem der vorhergehenden Ansprüche 6 bis 9, **dadurch gekennzeichnet, dass** die Arclöschanordnung (23.1, 23.2, 23.3) keine galvanische Verbindung zu einem Massepotential aufweist.

11. Arclöschanordnung nach einem der vorhergehenden Ansprüche 6 bis 10, **dadurch gekennzeichnet, dass** eine Entladungsvorrichtung (37) zum Entladen des Energiespeichers (30) vorgesehen ist.

12. Arclöschanordnung nach einem der vorhergehenden Ansprüche 6 bis 11, **dadurch gekennzeichnet, dass** eine Spannungsüberwachung (50) vorgesehen ist, die bei Unterschreiten eines vorgegebenen Spannungswerts die Entladungsvorrichtung (37) zum Entladen des Energiespeichers (30) deaktiviert.

13. Arclöschanordnung nach einem der vorhergehenden Ansprüche 6 bis 12, **dadurch gekennzeichnet, dass** dem Energiespeicher (30) entnommene Energie zumindest teilweise über einen der Entladungsvorrichtung (37) nachgeschaltete Energieumwandlungsvorrichtung (25) der Leistungsversorgung rückführbar ist.

## Claims

1. Method for extinguishing an arc in a gas discharge chamber (5) in which power is supplied to a gas discharge chamber (5) in which both with a current flow in a first direction and with a current flow in a second inverse direction there is produced a gas discharge, in which upon detection of an arc, the power supply to the gas discharge chamber (5) is interrupted, wherein, when an arc is detected, residual energy which is in a supply line (17, 19) to the gas discharge chamber (5) and/or in the gas discharge chamber (5) is supplied to one energy store (30) and, when an arc is detected, the power supply to the gas discharge chamber (5) is interrupted by opening two switches (S1, S2) which are arranged in a supply line (17, 19) and are connected to the energy store in that the switches (S1, S2) are opened when an arc is detected and the voltage (Us) across at least one switch (S1, S2) is limited to a voltage of the energy store (30), wherein both residual energy caused by current flow in the first direction and residual energy caused by current flow in the second direction is supplied exclusively to one energy store (30).

2. Method according to claim 1, **characterised in that**, owing to non-linear components, the return flow of energy from the energy store (30) into the supply line (17, 19) to the gas discharge chamber (5) and/or in the gas discharge chamber (5) is reduced or prevented.

3. Method according to claim 1 or claim 2, **characterised in that** the energy store (30) is precharged to a predetermined storage state during arc-free operation.

4. Method according to any one of the preceding claims, **characterised in that** the energy store (30) is discharged to a predetermined storage state after successful arc extinction.

5. Method according to any one of the preceding claims, **characterised in that**, by the residual energy being supplied to the energy store (30), a voltage reversal is produced in the supply lines (17, 19).

6. Arc extinction arrangement (23.1, 23.2, 23.3) which comprises at least partially a supply line (17, 19) for the connection between a power supply system and an electrode (3, 4) of a gas discharge chamber (5), a gas discharge being able to be produced in the gas discharge chamber (5) both with a current flow in a first direction and with a current flow in a second inverse direction, respectively, having an arc extinction device (18, 18.1, 18.2), wherein the arc extinction device has an energy store for receiving energy present in a supply line to the gas discharge chamber and/or in the gas discharge chamber, and wherein the arc extinction device (18, 18.1, 18.2) has two switches (S1, S2) which are arranged in a supply line (17, 19) which extends from the power supply system to one of the electrodes (3, 4) of the gas discharge chamber (5) and which can be opened to interrupt the power supply when an arc is detected, wherein the switches (S1, S2) are connected to the energy store (30) in such a manner that the voltage (Us) across at least one switch (S1, S2) is limited to a voltage of the energy store (30) and the arc extinction arrangement (23.1, 23.2, 23.3) is designed such that both residual energy caused by current flow in the first direction and residual energy caused by current flow in the second direction is supplied exclusively to one energy store (30) .

7. Arc extinction arrangement according to claim 6, **characterised in that** the arc extinction device (18, 18.1, 18.2) has non-linear components, in particular diodes (D3, D4), which are arranged in such a manner that a power flow from the energy store (30) into the supply lines (17, 19) and the gas discharge chamber (5) is reduced or prevented.

8. Arc extinction arrangement according to any one of the preceding claims 6 to 7, **characterised in that** a node point (VP1) of a supply line is connected to a capacitor of the energy store (30) by means of a rectifying element, in particular a diode (D7), in order to precharge the energy store (30).

9. Arc extinction arrangement according to any one of the preceding claims 6 to 8, **characterised in that** the arc extinction device (18, 18.1, 18.2) is constructed in a symmetrical manner, there being provided two diodes (D3, D4) which are arranged in series and two switch arrangements, and the energy store (30) being connected between the connection point (VP1) of the diodes (D3, D4) and the connection point (VP2) of the switch arrangements.

10. Arc extinction arrangement according to any one of the preceding claims 6 to 9, **characterised in that** the arc extinction arrangement (23.1, 23.2, 23.3) has no galvanic connection with respect to an earth potential.

11. Arc extinction arrangement according to any one of the preceding claims 6 to 10, **characterised in that** there is provided a discharging device (37) for discharging the energy store (30).

12. Arc extinction arrangement according to any one of the preceding claims 6 to 11, **characterised in that** there is provided a voltage monitoring system (50) which deactivates the discharging device (37) for discharging the energy store (30) when a predetermined voltage value is fallen below.

13. Arc extinction arrangement according to any one of the preceding claims 6 to 12, **characterised in that** energy removed from the energy store (30) can be at least partially returned to the power supply system by means of an energy conversion device (25) which is connected downstream of the discharging device (37).

## Revendications

1. Procédé dévolu à l'extinction d'un arc dans une chambre (5) de décharge gazeuse, dans lequel une puissance est délivrée à une chambre (5) de décharge gazeuse dans laquelle une décharge gazeuse est respectivement engendrée aussi bien en présence d'une circulation de courant dans une première direction, qu'en présence d'une circulation de courant dans une seconde direction opposée, procédé dans lequel la délivrance de puissance à ladite chambre (5) de décharge gazeuse est interrompue lors de la détection d'un arc, sachant que, lors de la détection d'un arc, de l'énergie résiduelle présente dans un conducteur d'arrivée (17, 19) gagnant la chambre (5) de décharge gazeuse, et/ou dans ladite chambre (5) de décharge gazeuse, est délivrée à un accumulateur d'énergie (30), et que, lors de la détection d'un arc, la délivrance de puissance à ladite chambre (5) de décharge gazeuse est interrompue par ouverture de deux interrupteurs (S1, S2) intégrés dans un conducteur d'arrivée (17, 19) et connectés audit accumulateur d'énergie, en ce sens que, lors de la détection d'un arc, lesdits interrupteurs (S1, S2) sont ouverts et la tension (Us) à travers au moins un interrupteur (S1, S2) est limitée à une tension dudit accumulateur d'énergie (30), aussi bien une énergie résiduelle provoquée par circulation de courant dans la première direction, qu'une énergie résiduelle provoquée par circulation de courant dans la seconde direction, étant délivrées exclusivement à un accumulateur d'énergie (30).

2. Procédé selon la revendication 1, **caractérisé par le fait que** le renvoi d'énergie à partir de l'accumulateur d'énergie (30), vers le conducteur d'arrivée (17, 19) gagnant la chambre (5) de décharge gazeuse et/ou dans ladite chambre (5) de décharge gazeuse, est atténué ou interdit par des composants non linéaires.

3. Procédé selon la revendication 1 ou 2, **caractérisé par le fait que** l'accumulateur d'énergie (30) est chargé préalablement, en mode fonctionnement sans arc, jusqu'à un état d'accumulation préétabli.

4. Procédé selon l'une des revendications précédentes, **caractérisé par le fait qu'**à l'issue de l'extinction de l'arc, l'accumulateur d'énergie (30) est déchargé jusqu'à un état d'accumulation préétabli.

5. Procédé selon l'une des revendications précédentes, **caractérisé par le fait que** l'introduction de l'énergie résiduelle dans l'accumulateur d'énergie (30) engendre une inversion de tension dans les conducteurs d'arrivée (17, 19).

6. Ensemble (23.1, 23.2, 23.3) d'extinction d'arcs muni, au moins par zones, d'un conducteur d'arrivée (17, 19) dévolu à la jonction entre une alimentation en puissance et une électrode (3, 4) d'une chambre (5) de décharge gazeuse, une décharge gazeuse pouvant être respectivement engendrée, dans ladite chambre (5) de décharge gazeuse, aussi bien en présence d'une circulation de courant dans une première direction, qu'en présence d'une circulation de courant dans une seconde direction opposée, avec un dispositif (18, 18.1 18.2) d'extinction d'arcs, ledit dispositif d'extinction d'arcs étant doté d'un accumulateur d'énergie conçu pour absorber de l'énergie présente dans un conducteur d'arrivée gagnant la chambre de décharge gazeuse, et/ou dans ladite chambre de décharge gazeuse, et ledit dispositif (18, 18.1 18.2) d'extinction d'arcs étant pourvu de deux interrupteurs (S1, S2) qui sont intégrés dans un conducteur d'arrivée (17, 19) partant de l'alimentation en puissance et gagnant l'une des électrodes (3, 4) de la chambre (5) de décharge gazeuse, et qui peuvent être ouverts, lors de la détection d'un arc, afin d'interrompre la délivrance de puissance, lesdits interrupteurs (S1, S2) étant connectés audit accumulateur d'énergie (30) de façon telle que la tension (Us) à travers au moins un interrupteur (S1, S2) soit limitée à une tension dudit accumulateur d'énergie (30), et ledit ensemble (23.1, 23.2, 23.3) d'extinction d'arcs étant agencé de telle manière qu'aussi bien une énergie résiduelle provoquée par circulation de courant dans la première direction, qu'une énergie résiduelle provoquée par circulation de courant dans la seconde direction, soient délivrées exclusivement à un accumulateur d'énergie (30).

7. Ensemble d'extinction d'arcs selon la revendication 6, **caractérisé par le fait que** le dispositif (18, 18.1 18.2) d'extinction d'arcs est muni de composants non linéaires, notamment de diodes (D3, D4) disposées de manière à atténuer ou à interdire un flux de puissance pénétrant dans les conducteurs d'arrivée (17, 19) et dans la chambre (5) de décharge gazeuse, en provenance de l'accumulateur d'énergie (30).

8. Ensemble d'extinction d'arcs selon l'une des revendications précédentes 6 à 7, **caractérisé par le fait qu'**un point nodal (VP1) d'un conducteur d'arrivée est raccordé par l'intermédiaire d'un élément redresseur, notamment d'une diode (D7), à un condensateur de l'accumulateur d'énergie (30) en vue du chargement préalable dudit accumulateur d'énergie (30).

9. Ensemble d'extinction d'arcs selon l'une des revendications précédentes 6 à 8, **caractérisé par le fait que** le dispositif (18, 18.1 18.2) d'extinction d'arcs présente un agencement structurel symétrique dans lequel sont prévus deux diodes (D3, D4) disposées en série, et deux ensembles d'interrupteurs, l'accumulateur d'énergie (30) étant mis en circuit entre le point de jonction (VP1) desdites diodes (D3, D4) et le point de jonction (VP2) desdits ensembles d'interrupteurs.

10. Ensemble d'extinction d'arcs selon l'une des revendications précédentes 6 à 9, **caractérisé par le fait que** ledit ensemble (23.1, 23.2, 23.3) d'extinction d'arcs ne comporte aucune liaison galvanique avec un potentiel de masse.

11. Ensemble d'extinction d'arcs selon l'une des revendications précédentes 6 à 10, **caractérisé par le fait qu'**un dispositif de déchargement (37) est prévu pour décharger l'accumulateur d'énergie (30).

12. Ensemble d'extinction d'arcs selon l'une des revendications précédentes 6 à 11, **caractérisé par** la présence d'une surveillance de tension (50) qui, en cas de dépassement négatif d'une valeur de tension préétablie, désactive le dispositif de déchargement (37) affecté au déchargement de l'accumulateur d'énergie (30).

13. Ensemble d'extinction d'arcs selon l'une des revendications précédentes 6 à 12, **caractérisé par le fait que** de l'énergie prélevée de l'accumulateur d'énergie (30) peut être renvoyée, au moins en partie, par l'intermédiaire d'un dispositif (25) convertisseur d'énergie de l'alimentation en puissance, branché en aval du dispositif de déchargement (37).
